Europäisches Patentamt

European Patent Office

Office européen des brevets

(11) Veröffentlichungsnummer: **0 243 812**
**A1**

(12) **EUROPÄISCHE PATENTANMELDUNG**

(21) Anmeldenummer: **87105650.3**

(22) Anmeldetag: **16.04.87**

(51) Int. Cl.⁴: **G01R 31/32** , **H01H 33/66**

(30) Priorität: **30.04.86 CH 1774/86**

(43) Veröffentlichungstag der Anmeldung:
**04.11.87 Patentblatt 87/45**

(84) Benannte Vertragsstaaten:
**CH DE IT LI NL**

(71) Anmelder: **BBC Brown Boveri AG**

**CH-5401 Baden(CH)**

(72) Erfinder: **Fröhlich, Klaus, Dr.**
**Baldeggstrasse 11**
**CH-5400 Baden(CH)**

(54) **Prüfkreis.**

(57) Ein Prüfkreis für die synthetische Prüfung des Ausschaltvermögens von elektrischen Leistungs- schaltern, setzt sich zusammen aus einem Hoch- spannungskreis und einem von einem Prüfstrom durchflossenen Hochstromkreis. Im Hochstromkreis sind ein Hilfsschalter und ein Prüfschalter (8) in Reihe geschaltet, wobei der Hilfsschalter mindestens zwei parallele Strompfade aufweist. In jedem dieser Strompfade liegt jeweils mindestens eine Vakuum- schaltröhre (19) mit einer durch ein axiales Magnet- feld beaufschlagten Unterbrechungsstelle (22).

Die Vakuumschaltröhren (19) sind jeweils im Be- reich der Unterbrechungsstelle (22) mit zwei konzentrischen Spulen (23, 24) versehen, welche gleich bemessen sind, gleichsinnig vom Prüfstrom durchflossen werden und ein axiales Magnetfeld im Bereich der Unterbrechungsstelle (22) erzeugen.

FIG.3

EP 0 243 812 A1

## PRÜFKREIS

Die Erfindung geht aus von einem Prüfkreis gemäss dem ersten Teil des Anspruchs 1.

Aus der Veröffentlichung von S. Tamura u.a. mit dem Titel: "Parallel Interruption of Heavy Direct Current by Vakuum Circuit Breakers (IEEE Transactions on Power Apparatus and Systems, Vol. PAS-99, No. 3, 1980, Seiten 1119 bis 1126)" ist ein Prüfkreis für die Prüfung des Ausschaltvermögens von elektrischen Leistungsschaltern bekannt. Dieser Prüfkreis weist im Hochstromkreis einen aus parallel-und reihengeschalteten Vakuumschaltröhren mit jeweils einer Unterbrechungsstelle bestehenden Hilfsschalter in Reihe zu einem Prüfschalter auf. Jede dieser Unterbrechungsstellen ist durch zwei Kontakte, von denen einer beweglich ist, begrenzt und wird durch ein von einer innerhalb der Vakuumschaltröhre liegenden Anordnung erzeugtes axiales Magnetfeld beaufschlagt. Diese Anordnung weist eine geringe Impedanz auf, was zur Folge hat, dass keine hinreichend gleichmässige Stromverteilung auf die parallel geschalteten Vakuumschaltröhren gewährleistet ist.

Hier will die Erfindung Abhilfe schaffen. Die Erfindung, wie sie in den Ansprüchen gekennzeichnet ist, löst die Aufgabe einen Prüfkreis der gattungsgemässen Art zu schaffen, in welchem im Hochstromkreis ein Hilfsschalter vorgesehen ist, bei welchem mit einfachen Mitteln eine gleichmässige Stromverteilung auf die parallel geschalteten Vakuumschaltröhren erreicht wird.

Die durch die Erfindung erreichten Vorteile sind im wesentlichen darin zu sehen, dass der Hilfsschalter mit weniger und bezüglich ihrer Stromtragfähigkeit besser ausgenützten Vakuumschaltröhren und damit wirtschaftlicher erstellt werden kann. Ferner ist es möglich, nun auch in Prüfstrom-und Spannungsbereichen eine korrekte synthetische Prüfung des Ausschaltvermögens durchzuführen, in welchen dies bisher wirtschaftlich nicht möglich gewesen ist.

Die weiteren Ausgestaltungen der Erfindung sind Gegenstände abhängiger Ansprüche.

Nachfolgend wird die Erfindung anhand von Zeichnungen näher erläutert.

Hierbei zeigt:

Fig. 1 eine einfache Ausführungsform des erfindungsgemässen Prüfkreises,

Fig. 2 eine vereinfachte, nicht massstäbliche Skizze der Strom-und Spannungsverläufe bei einer Leistungsprüfung mit dem Prüfkreis gemäss Fig. 1,

Fig. 3 eine schematische Darstellung eines Elementes für einen baukastenartigen Aufbau des Hilfsschalters,

Fig. 4 eine schematische Darstellung einer ersten Hilfsschalterausführung,

Fig. 5 eine schematische Darstellung einer zweiten Hilfsschalterausführung, und

Fig. 6 eine schematische Darstellung einer dritten Hilfsschalterausführung.

Bei allen Figuren sind gleich wirkende Elemente mit gleichen Bezugszeichen versehen.

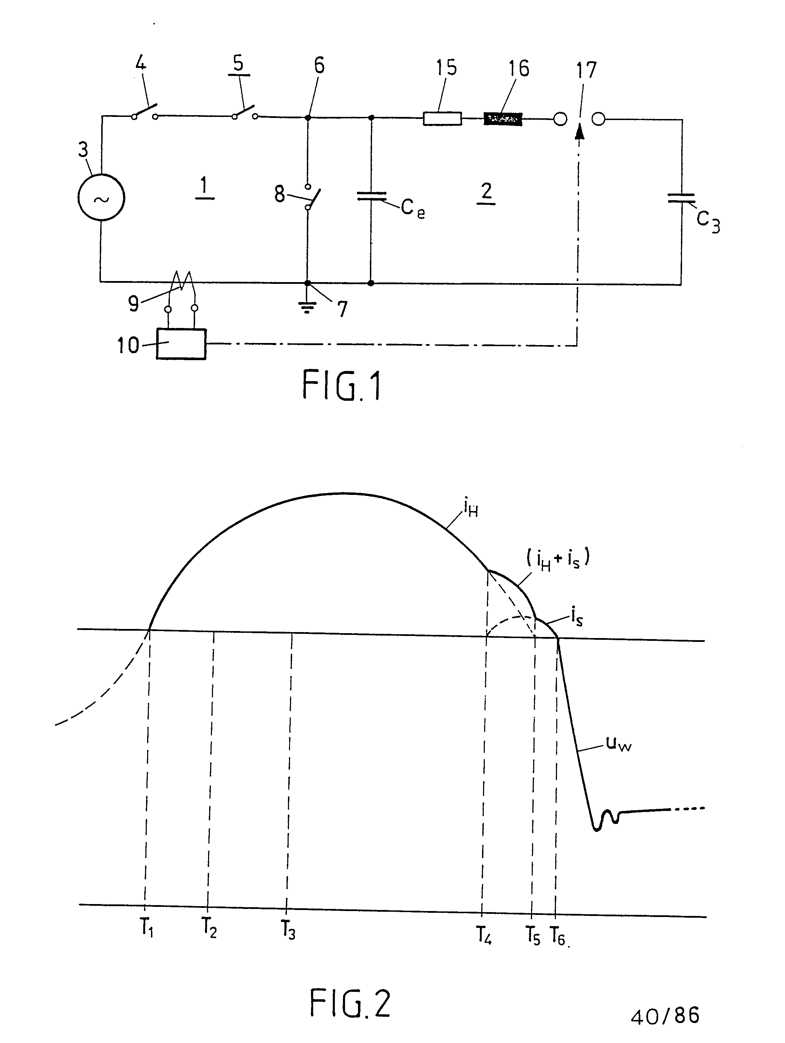

Der Prüfkreis gemäss Fig. 1 besteht aus einem Hochstromkreis 1 und aus einem mit diesem verbundenen Hochspannungskreis 2. Im Hochstromkreis 1 sind eine Spannungsquelle 3, ein Draufschalter 4, ein Hilfsschalter 5 und ein. zwischen Abgangsklemmen 6, 7 liegender, Prüfschalter 8 in Reihe geschaltet. Die Abgangsklemme 7 ist in der Regel geerdet. Ueber einen als Stromwandler ausgebildeten Sensor 9 werden bei geschlossenem Hochstromkreis 1 stromproportionale Signale abgegriffen und in eine elektronische Steuereinheit 10 zur weiteren Verarbeitung geleitet. Der Hochspannungskreis 2 weist einen zum Prüfschalter 8 parallel geschalteten Kondensator $C_e$ auf, ferner parallel zum Kondensator $C_e$ eine Reihenschaltung aus einem Widerstand 15, einer Induktivität 16, einer von der Steuereinheit 10 her triggerbaren Funkenstrecke 17 und einer Kondensatorbatterie $C_3$, wobei die Grössen dieser Schaltelemente unter Beachtung der bekannten Zusammenhänge bestimmt werden.

Zur Erläuterung der Wirkungsweise des Prüfkreises, seien Fig. 1 und Fig. 2 gemeinsam näher betrachtet. Zunächst sind der Hilfsschalter 5 und der Prüfschalter 8 geschlossen und der Draufschalter 4 ist offen. In einem Zeitpunkt $T$. wird der Draufschalter 4 geschlossen und der Prüfstrom $i_H$ beginnt, gespeist durch die Spannungsquelle 3, im Hochstromkreis 1 zu fliessen. In einem durch die vorgegebenen Prüfbedingungen bestimmten Zeitpunkt $T_2$ wird der Prüfschalter 8 geöffnet. Im Prüfschalter 8 brennt nun ein Lichtbogen. Danach wird in einem Zeitpunkt $T_3$ der Hilfsschalter 5 geöffnet und in diesem ein weiterer Lichtbogen eingeleitet. Der Hilfsschalter 5 weist jedoch eine vergleichsweise niedrige Lichtbogenspannung auf. welche den Verlauf des Prüfstromes $i_H$ nur unwesentlich beeinflusst. In einem Zeitpunkt $T_4$ wird die Funkenstrecke 17 von der Steuereinheit 10 her getriggert und zündet durch, da die Kondensatorbatterie $C_3$ auf die volle Prüfspannung aufgeladen ist. In bekannter Weise wird darauf ein allein vom Hochspannungskreis 2 gespeister Schwingstrom $i_s$ dem Prüfstrom $i_H$ überlagert zu einem Strom $(i_H + i_s)$, welcher bis zu einem Zeitpunkt $T_5$ fliesst. Im Zeitpunkt $T_5$ löscht der Hilfsschalter 5 den Prüfstrom $i_H$, während der Schwingstrom $i_s$ einige hundert Mikrosekunden weiterfliesst bis zu einem Zeitpunkt $T_6$. Im Zeitpunkt $T_6$ löscht der Prüfschalter 8 definitiv. Nach dieser Löschung in T₆ beginnt die wiederkehrende Spannung u_w über dem Prüfschalter 8 anzusteigen, die vom Hochspannungskreis 2 geliefert wird. Erfolgt dieser Anstieg der wiederkehrenden Spannung u_w ohne Rückzündungen, so ist diese Leistungsabschaltung für den Prüfschalter 8 erfolgreich verlaufen.

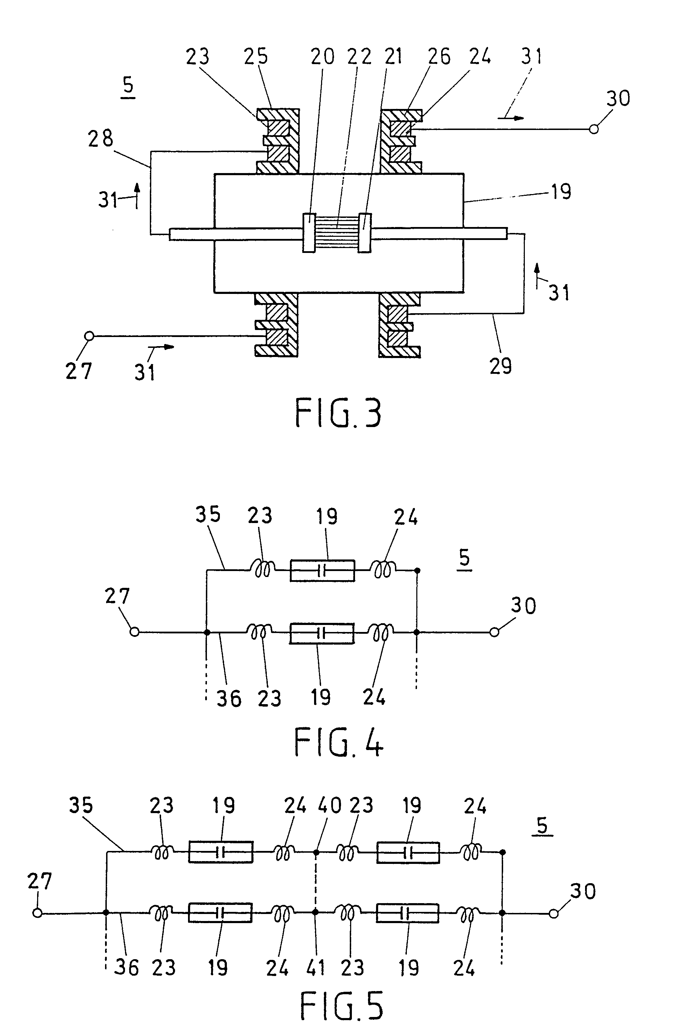

In Fig. 3 wird eine einfache schematische Darstellung eines Elementes eines Hilfsschalters 5 gezeigt. In einer Vakuumschaltröhre 19 bilden zwei Kontakte 20, 21, von denen der eine mittels eines nicht dargestellten Antriebes beweglich ist, eine Unterbrechungsstelle 22. Zwei gleich bemessene Spulen 23, 24 umgeben die Vakuumschaltröhre 19 im Bereich der Unterbrechungsstelle 22 konzentrisch und sind mit dieser über isolierende Halterungen 25, 26 mechanisch verbunden. Die Spulen 23, 24 sind im gleichen Abstand von der geöffneten Unterbrechungsstelle 22 angeordnet und ihre Längsachse ist deckungsgleich mit der Längsachse der Vakuumschaltröhre 19. Ferner ist der Abstand zwischen den beiden Spulen 23, 24 keinesfalls grösser als etwa dem inneren Spulendurchmesser entsprechend. Jede der beiden Spulen 23, 24 weist die gleiche Anzahl Windungen auf, und zwar mindestens eine und höchstens fünf, vorzugsweise jedoch zwei Windungen. Die Spulen 23, 24 können ein-oder mehrlagig gewickelt sein, wobei die Windungszahl nicht ganzzahlig zu sein braucht. Eine Eingangsklemme 27 ist mit einem Ende der Spule 23 elektrisch leitend verbunden, deren anderes Ende über ein angedeutetes elektrisch leitendes Verbindungsstück 28 mit dem Kontakt 20 verbunden ist. Der Kontakt 21 ist über ein weiteres angedeutetes Verbindungsstück 29 mit einem Ende der Spule 24 verbunden, deren anderes Ende mit einer Abgangsklemme 30 verbunden ist.

Pfeile 31 deuten einen Strompfad an, durch welchen ein Teil des Prüfstromes i_H durch dieses einfache Hilfsschalterelement fliessen kann. Der Teil des Prüfstromes i_H durchfliesst zuerst die der Vakuumschaltröhre 19 vorgeschaltete Spule 23, und danach die dieser nachgeschaltete Spule 24. Die beiden gleich bemessenen und identisch aufgebauten Spulen 23, 24 werden von diesem Prüfstromteil gleichsinnig durchflossen und erzeugen gemeinsam ein auf die Unterbrechungsstelle 22 und den in dieser bestehenden Lichtbogen einwirkendes axiales Magnetfeld. Im Bereich der Unterbrechungsstelle 22 ist dieses Magnetfeld dank der geometrischen Anordnung der Spulen 23, 24 nahezu homogen, ferner ist es proportional zum Prüfstrom i_H und bewirkt, dass der Lichtbogen auch bei Stromwerten im Bereich von 50 kA und darüber diffus brennt, so dass der Kontaktabbrand der Unterbrechungsstelle 22 in beherrschbaren Grenzen bleibt. Im nächsten Nulldurchgang des Prüfstromes i_H wird dieser gelöscht. Derartige, vergleichsweise hohe Stromwerte können nur dank des, bedingt durch die vergleichsweise grosse Windungszahl der Spulen 23 und 24, starken axialen Magnetfeldes beherrscht werden.

Wie die Fig. 4 schematisch zeigt, können zwecks Erhöhung des durch den Hilfsschalter 5 beherrschbaren Prüfstromes i_H zwei oder mehrere der in Fig. 3 dargestellten Elemente zu einem Hilfsschalter 5 mit mehreren Strompfaden 35, 36, ... parallel geschaltet werden. Dank der jeder Vakuumschaltröhre 19 vor-und nachgeschalteten gleich bemessenen und identisch aufgebauten Spulen 23, 24 und deren vergleichsweise hohen Impedanzen, weist jeder der Strompfade 35, 36, ... die gleiche Impedanz mit einem überwiegend induktiven Anteil auf, so dass sich der bei der Eingangsklemme 27 eingespeiste Prüfstrom i_H gleichmässig auf die einzelnen parallelen Strompfade 35, 36, ... aufteilt. Auf diese Art wird mit grosser Sicherheit vermieden, dass einzelne Vakuumschaltröhren 19 strommässig überlastet werden. Infolgedessen kann jede dieser Vakuumschaltröhren 19 voll bis an die Grenze ihres Leistungsvermögens belastet werden, so dass keine zusätzlichen Sicherheitsmargen nötig sind.

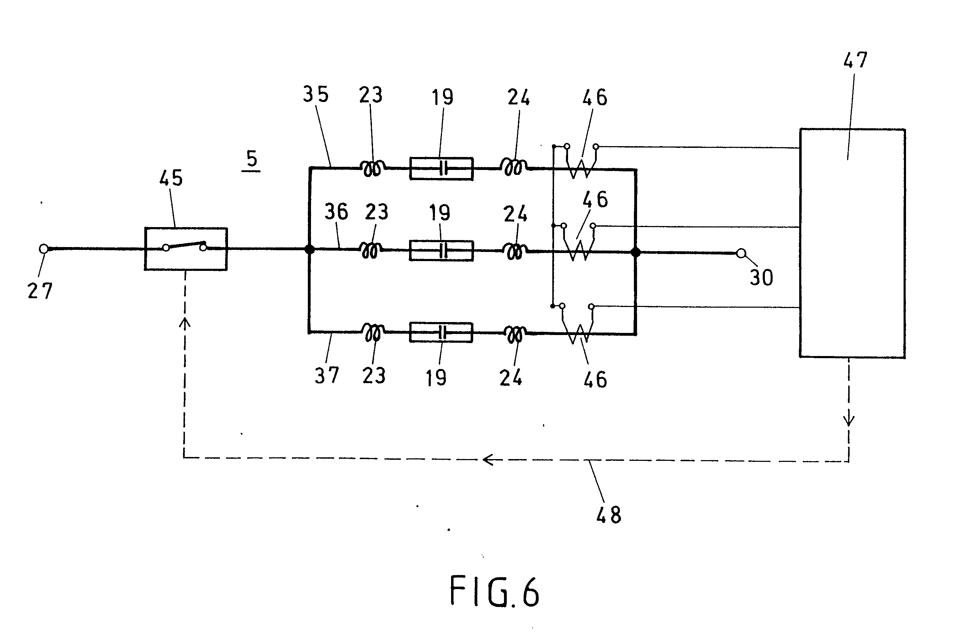

Fig. 5 zeigt schematisch einen sowohl bezüglich des beherrschbaren Prüfstromes i_H als auch bezüglich der beherrschbaren Spannung verstärkten Hilfsschalter 5. Bei diesem Hilfsschalter 5 sind Strompfade 35, 36, ... parallel geschaltet und in jedem dieser Strompfade 35, 36, ... sind zwei der in Fig. 3 dargestellten Elemente in Reihe geschaltet. Für höhere Spannungen kann die Anzahl der in Reihe geschalteten Elemente auch erhöht werden. Im Strompfad 35 ist eine Klemme 40 und im Strompfad 36 eine Klemme 41 zwischen den in Reihe geschalteten Elementen vorgesehen. Diese Klemmen 40, 41, ... können, da sie gleiches Potential aufweisen, auch elektrisch leitend verbunden sein. Bei diesem Hilfsschalter 5 ist ebenfalls, dank den vergleichsweise hohen Impedanzen der gleich bemessenen Spulen 23, 24, eine gleichmässige Aufteilung des Prüfstromes auf die einzelnen parallelen Strompfade 35, 36, ... sichergestellt, so dass das erhöhte Leistungsvermögen der einzelnen Vakuumschaltröhren 19 voll und ohne Sicherheitsmargen ausgenützt werden kann.

Aus Fig. 6 ist ein Hilfsschalter 5 mit beispielsweise drei parallelen Strompfaden 35, 36, 37 ersichtlich. Zusätzlich ist in diesem Hilfsschalter 5 eine vom vollen Prüfstrom i_H durchflossene und nach einer Auslösung sehr schnell strombegrenzend wirkende und sehr schnell abschaltende Hochleistungs-Schalteinrichtung (I_S-Begrenzer 45) vorgesehen. Der I_S-Begrenzer 45 ist hier zwischen der Eingangsklemme 27 und der Verzweigungsstelle der drei parallelen Strompfade 35, 36, 37 angeordnet. In jedem der parallelen Strompfade 35, 36, 37 ist ein Sensor 46 zur Messung des im betreffenden Strompfad fliessenden Teils des Prüfstromes $i_H$ vorgesehen. Die Ausgangssignale dieser Sensoren 46 werden in einer Auswerteeinheit 47 überwacht und verarbeitet. Die Auswerteeinheit 47 kann, wie durch die gestrichelte Wirkungslinie 48 angedeutet, auf den $I_S$-Begrenzer 45 einwirken und ihn auslösen. Eine derartige Auslösung des $I_S$-Begrenzers 45 muss dann stattfinden, wenn in den Strompfaden 35, 36, 37 eine unsymmetrische Stromverteilung auftritt. Dies kann der Fall sein, wenn eine der Vakuumschaltröhren 19 beim Abschalten versagt oder wegen eines mechanischen Defektes nicht öffnet. Die Auswerteeinheit 47 ist so ausgelegt, dass derartige unsymmetrische Stromverteilungen sehr rasch erkannt werden. Der $I_S$-Begrenzer 45 erhält dann sofort einen Auslösebefehl und schaltet den Prüfstrom $i_H$ durch den Hilfsschalter 5 noch in dessen Anstiegsbereich ab, ehe dieser Werte erreichen kann, bei welchen Sekundärschäden auftreten können. Es wird also mit Hilfe des $I_S$-Begrenzers 45 sicher verhindert, dass eine beispielsweise beim Abschalten versagende Schaltröhre 19 mit dem vollen Prüfstrom $i_H$ belastet und damit eventuell bis zur Zerstörung überlastet wird.

Der erfindungsgemässe Prüfkreis kann dank des baukastenartig erweiterbaren Hilfsschalters in einem weiten Bereich den Prüfanforderungen angepasst werden. Damit sind nun auch in Prüfstrom- und Spannungsbereichen, welche bisher einer korrekten synthetischen Abschaltleistungsprüfung nicht zugänglich waren, derartige Prüfungen mit vertretbarem wirtschaftlichem Aufwand möglich geworden. In allen diesen Bereichen wirkt sich dazu der vergleichsweise kleine Aufwand für Hilfsschalterrevisionen besonders vorteilhaft aus, ebenso die stark erhöhte Anzahl möglicher Ausschaltungen von einer Hilfsschalterrevision bis zur nächsten.

**Ansprüche**

1. Prüfkreis für die synthetische Prüfung des Ausschaltvermögens von elektrischen Leistungsschaltern (Prüfschalter 8) mit mindestens einem Hochspannungskreis (2) und mit einem von einem Prüfstrom durchflossenen Hochstromkreis (1), in welchem ein Hilfsschalter (5) und ein Prüfschalter (8) in Reihe geschaltet angeordnet sind, wobei der Hilfsschalter (5) mindestens zwei parallele Strompfade (35, 36) mit jeweils mindestens einer Vakuumschaltröhre (19) mit jeweils mindestens einer Unterbrechungsstelle (22) und mit jeweils einer Anordnung zur Erzeugung eines axialen Magnetfeldes für die Beaufschlagung der mindestens einen Unterbrechungsstelle (22) aufweist, dadurch gekennzeichnet,
-dass die Anordnung zur Erzeugung des axialen Magnetfeldes mindestens zwei gleich bemessene und gleichsinnig vom Prüfstrom durchflossene Spulen (23, 24) auswiest, und
-dass diese Spulen (23, 24) die Vakuumschaltröhre (19) im Bereich der mindestens einen Unterbrechungsstelle (22) konzentrisch umgeben.

2. Prüfkreis nach Anspruch 1, dadurch gekennzeichnet,
-dass eine erste (23) der mindestens zwei gleich bemessenen Spulen (23, 24) jeder Vakuumschaltröhre (19) elektrisch vorgeschaltet und eine zweite (24) dieser Spulen (23, 24) jeder Vakuumschaltröhre (19) nachgeschaltet ist.

3. Prüfkreis nach einem der Ansprüche 1 oder 2, dadurch gekennzeichnet,
-dass jede der mindestens zwei gleich bemessenen Spulen (23, 24) in gleichem Abstand von der geöffneten Unterbrechungsstelle (22) angeordnet ist.

4. Prüfkreis nach einem der Ansprüche 1 bis 3, dadurch gekennzeichnet,
-dass jede der mindestens zwei gleich bemessenen Spulen (23, 24) mindestens eine und höchstens fünf, vorzugsweise jedoch zwei Windungen aufweist, und
-dass diese Spulen (23, 24) keinesfalls weiter voneinander beabstandet sind, als etwa dem inneren Spulendurchmesser entsprechend.

5. Prüfkreis nach einem der Ansprüche 1 bis 5, dadurch gekennzeichnet,
-dass jeder der mindestens zwei parallelen Strompfade (35, 36) die gleiche Impedanz aufweist, und
-dass bei dieser Impedanz der induktive Anteil überwiegt.

6. Prüfkreis nach einem der Ansprüche 1 bis 5, dadurch gekennzeichnet,
-dass im Hilfsschalter (5) ein vom Prüfstrom $i_H$ durchflossener $I_S$-Begrenzer (45) angeordnet ist.

7. Prüfkreis nach Anspruch 6, dadurch gekennzeichnet,
-dass in jedem der mindestens zwei parallelen Strompfade (35, 36, 37) ein Sensor (46) vorgesehen ist, dessen Ausgang mit einer Auswerteeinheit (47) verbunden ist, und
-dass die Auswerteeinheit (47) mit dem $I_S$-Begrenzer (45) in Wirkverbindung steht.

FIG.1

FIG.2

FIG.3

FIG.4

FIG.5

FIG.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-3 217 167 (BBC)<br>* Seite 11, Zeile 19 - Seite 12, Zeile 10; Figuren 1, 2 *<br><br>--- | 1-3 | G 01 R 31/32<br>H 01 H 33/66 |
| Y | DE-B-2 709 363 (HAZEMEIJER B.V.)<br>* Ansprüche 1, 2, Spalte 3, Zeilen 37-48; Figur 1 *<br><br>--- | 1-3 | |
| A,D | IEEE TRANSACTIONS ON POWER APPARATUS AND SYSTEMS, Band PAS 99, Nr. 3, Mai/Juni 1980, Seiten 1119-1129, US; S. TAMURA et al.: "Parallel interruption of heavy direct current by vacuum circuit breakers"<br>* Seite 1122, Figur 6(a) *<br><br>----- | 1 | |

RECHERCHIERTE SACHGEBIETE (Int. Cl.4)

G 01 R 31/32
H 01 H 33/66

Der vorliegende Recherchenbericht wurde für alle Patentansprüche erstellt.

| Recherchenort | Abschlußdatum der Recherche | Prüfer |
|---|---|---|
| BERLIN | 23-07-1987 | LEMMERICH J |